# EUROPÄISCHE PATENTSCHRIFT

(11) **EP 0 895 708 B1**
(45) Veröffentlichungstag und Bekanntmachung des Hinweises auf die Patenterteilung: **13.10.1999**
(21) Anmeldenummer: 97922833.5
(22) Anmeldetag: 14.04.1997
(51) Int. Cl.: H05K 7/14, G05B 19/042

(54) **MODULARES, BAUGRUPPENWEISE ERWEITERBARES PERIPHERIEGERÄT MIT SELBSTAUFBAUENDER ELEKTRISCHER VERBINDUNG**
MODULAR PERIPHERAL UNIT EXPANDABLE BY MODULES AND HAVING AN AUTOMATICALLY ESTABLISHING ELECTRICAL CONNECTION
PERIPHERIQUE MODULAIRE EXTENSIBLE PAR MODULES ET A CONNEXION ELECTRIQUE S'ETABLISSANT AUTOMATIQUEMENT

(30) Priorität: 25.04.1996 DE 29607525 U
(43) Veröffentlichungstag der Anmeldung: 10.02.1999
(73) Patentinhaber: SIEMENS AKTIENGESELLSCHAFT, 80333 München (DE)
(72) Erfinder: BERGMANN, Martin, D-92253 Schnaittenbach (DE); RESTER, Heribert, D-92449 Steinberg (DE); SCHIRBL, Reinhard, D-92421 Schwandorf (DE)
(86) Internationale Anmeldenummer: DE9700749
(87) Internationale Veröffentlichungsnummer: WO9741714

(56) Entgegenhaltungen:
- EP-A- 0 499 675
- EP-A- 0 527 247
- DE-A- 3 740 290
- GB-A- 2 014 367
- US-A- 4 790 762

## Beschreibung

Die vorliegende Erfindung betrifft ein modulares, baugruppenweise erweiterbares Peripheriegerät zur Steuerung und/oder Überwachung eines technischen Prozesses. Das Peripheriegerät besteht aus einem Basismodul, dem zumindest eine Versorgungsspannung zuführbar ist, an das mindestens ein Erweiterungsmodul anreihbar ist. Dabei ist sowohl das Basismodul als auch das mindestens eine anreihbare Erweiterungsmodul mit Aktoren und/oder Sensoren zur Steuerung und/oder Überwachung des technischen Prozesses verbindbar.

Peripheriegeräte der oben beschriebenen Art sind im Stand der Technik allgemein bekannt. Die Firma Siemens AG liefert beispielsweise das modulare Peripheriegerat ET200U. Beim konventionellen Aufbau von Automatisierungsanlagen werden Sensoren und Aktoren direkt mit dem zentralen Automatisierungsgerat verbunden. Dies führt bei weit verzweigten Anlagen zu umfangreichen Verdrahtungen mit hohem Verdrahtungsaufwand und verringerter Flexibilität bei Änderungen und Ergänzungen.

Dezentrale Peripheriegeräte bilden daher eine effiziente Schnittstelle zwischen Prozeß und zentralem Automatisierungsgerat. Die Verarbeitung und Umsetzung der Prozeßsignale - die Interaktion mit Sensoren und Aktoren - erfolgt direkt vor Ort, also auch räumlich dem Prozeß oder dem Teilprozeß zugeordnet. Die Verbindung zwischen Peripheriegerät und zentralem Automatisierungsgerat erfolgt dabei üblicherweise über einen Feldbus und damit über eine einzelne Verbindung.

Im Stand der Technik sind ferner einstückige Peripheriegeräte mit hoher Schutzart (IP66/IP67) bekannt - z.B. das von der Firma Siemens AG vertriebene Peripheriegerät ET200C -, die sich vor allem für den Einsatz in rauher Industrieumgebung eignen.

Nicht bekannt sind dagegen Peripheriegeräte, bei denen sich die notwendigen elektrisch leitenden Verbindungen zwischen den einzelnen Modulen ohne zusätzliche Kontaktmittel wie z.B. Stecker oder Kabel während der Erweiterung ergeben. Ferner sind im Stand der Technik bisher keine modular erweiterbaren Peripheriegeräte bekannt, die bei hoher Schutzart gleichzeitig modular erweiterbar sind.

Aufgabe der Erfindung ist es, ein Peripheriegerät zur Steuerung und/oder Überwachung eines technischen Prozesses anzugeben, das baugruppenweise modular erweiterbar ist, wobei sich die erforderlichen elektrisch leitenden Verbindungen und Kontaktstellen beim Zusammenfügen des Peripheriegerätes ergeben.

Die Aufgabe wird für ein modulares, baugruppenweise erweiterbares Peripheriegerät nach dem Oberbegriff des Anspruchs 1, das aus einem Basismodul besteht, an das mindestens ein Erweiterungsmodul anreihbar ist, dadurch gelöst, daß
- die Module aus einem Moduloberteil und einem Modulunterteil bestehen,
- die Modulunterteile jeweils ein aneinander anreihfähiges Profil aufweisen,
- die Modulunterteile im Bereich des anreihfahigen Profils eine Vielzahl von im wesentlichen U-förmigen Kontaktelementen aufweisen,
- der eine Schenkel der U-förmigen Kontaktelemente sich bei aufgesetztem Moduloberteil innerhalb des Moduls befindet, so daß die Vielzahl dieser Schenkel der U-förmigen Kontaktelemente eine interne Kontaktanordnung bildet,
- der andere Schenkel der U-förmigen Kontaktelemente sich auch bei aufgesetztem Moduloberteil außerhalb des Moduls befindet, so daß die Vielzahl dieser Schenkel der U-förmigen Kontaktelemente eine externe Kontaktanordnung bildet,
- die externe Kontaktanordnung beim Anreihen eines Erweiterungsmoduls so in das Erweiterungsmodul eingreift, daß die externe Kontaktanordnung der internen Kontaktanordnung des angereihten Erweiterungsmoduls gegenüberliegt.

In einer vorteilhaften Ausgestaltung weisen die im wesentlichen U-förmigen Kontaktelemente LE Verzweigungen auf. Auf diese Weise bieten die U-förmigen Kontaktelemente die Möglichkeit für einen Mehrfachabgriff der am jeweiligen Kontaktelement anliegenden Signal- oder Versorgungsspannung.

In einer weiteren vorteilhaften Ausgestaltung dient ein Teil der im wesentlichen U-förmigen Kontaktelemente der Weiterleitung der mindestens einen Versorgungsspannung und ein Teil der im wesentlichen U-förmigen Kontaktelemente der Weiterleitung von Signalspannungen. Damit ist es in vorteilhafter Weise möglich, die Kontaktelemente sowohl zur Weiterleitung der mindestens einen Versorgungsspannung als auch zur Weiterleitung der Signalspannungen zu nutzen, wobei jedoch innerhalb des Moduls eine deutliche räumliche Trennung zwischen den Signalspannungen und der mindestens einen Versorgungsspannung gewährleistet ist.

In einer weiteren vorteilhaften Ausgestaltung zeichnet sich das Peripheriegerät dadurch aus, daß die Moduloberteile eine auf einer Leiterplatte aufgebrachte, den technischen Prozeß steuernde und/oder überwachende elektrische Schaltung aufweisen. Dies ist vor allem in Hinblick auf die Tatsache vorteilhaft, daß jedes Moduloberteil jeweils nur am korrespondierenden Modulunterteil mit mindestens einem Befestigungsmittel befestigt ist und daß die Betätigung der Befestigungsmittel durch andere Moduloberteile oder Modulunterteile nicht versperrt ist. Aus diesem Grunde kann die im Moduloberteil angeordnete, auf einer Leiterplatte aufgebrachte Elektronik oder elektrische Schaltung im Wartungsfalle oder bei einer Änderung der Anlagenkonfiguration leicht ausgetauscht werden, ohne dazu andere Moduloberteile oder gar die Verbindung zwischen den Modulunterteilen lösen zu müssen.

Weitere Vorteile und erfinderische Einzelheiten ergeben sich aus der nachfolgenden Beschreibung eines Ausführungsbeispiels anhand der Zeichnungen und in Verbindung mit den Unteransprüchen. Im einzelnen zeigen:
- FIG 1: ein modulares, baugruppenweise erweiterbares Peripheriegerät im zusammengefügten Zustand,
- FIG 2: ein modulares, baugruppenweise erweiterbares Peripheriegerät in der Teilexplosionsdarstellung,
- FIG 3: eine Draufsicht auf aneinandergereihte Modulunterteile,
- FIG 4: einen Schnitt durch das Peripheriegerät entlang der Schnittlinie IV und
- FIG 5: einen Schnitt durch das Peripheriegerät entlang der Schnittlinie V.

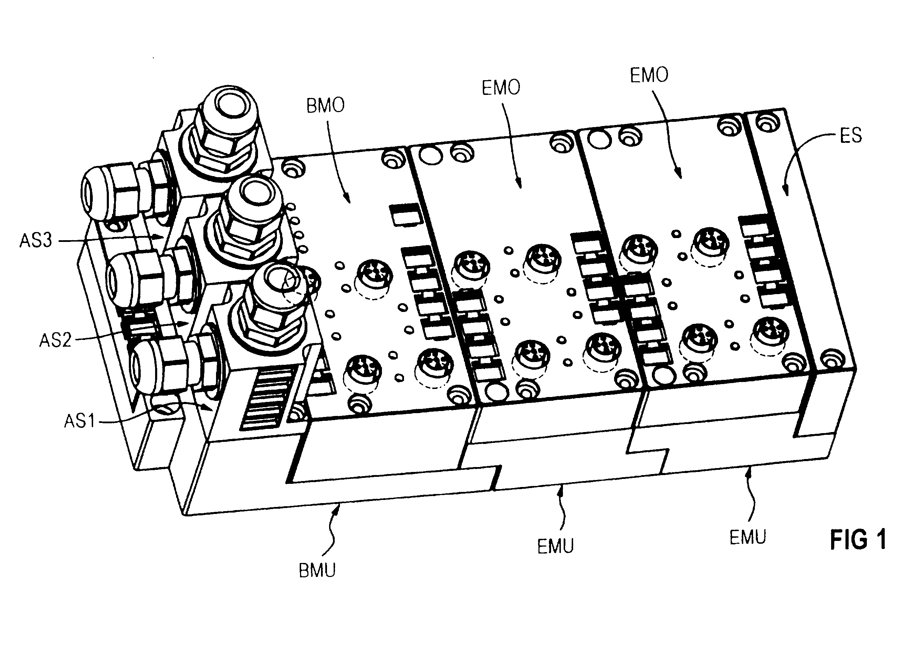

Gemäß FIG 1 besteht das Basismodul aus einem Basismodulunterteil BMU und einem Basismoduloberteil BMO. Entsprechend besteht das Erweiterungsmodul aus einem Erweiterungsmodulunterteil EMU und einem Erweiterungsmoduloberteil EMO.

Basismodulunterteil BMU und Erweiterungsmodulunterteil EMU - weisen ein anreihfähiges Profil auf, so daß das Basismodulunterteil BMU und das Erweiterungsmodulunterteil EMU bzw. das Erweiterungsmodulunterteil EMU und ein weiteres Erweiterungsunterteil EMU formschlüssig anreihbar sind. Im Ausführungsbeispiel kommt ein Stufenprofil zur Anwendung.

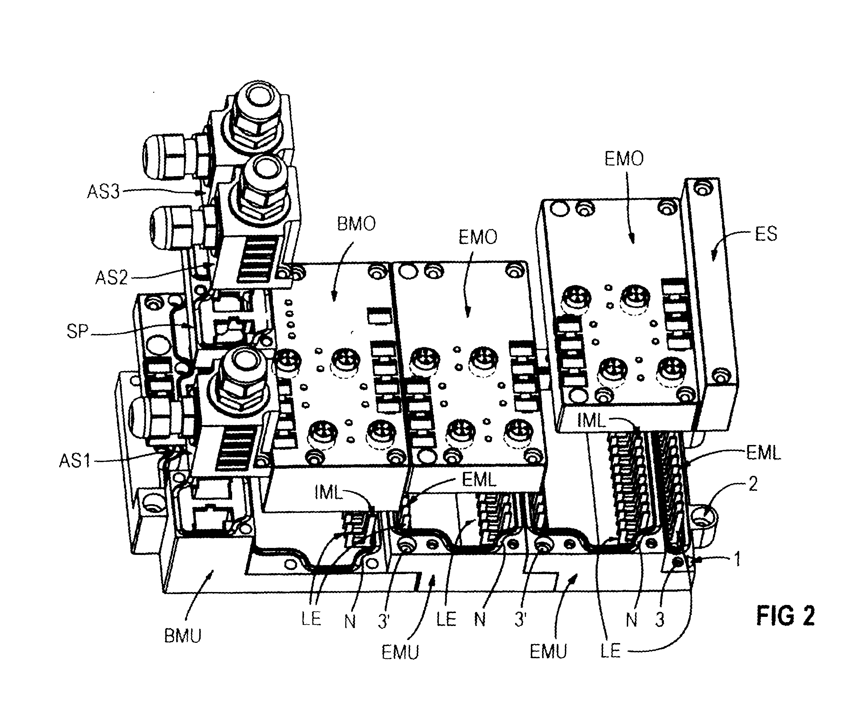

FIG 2 zeigt das Peripheriegerät PG in einer Teilexplosion, wobei die Modulunterteile BMU, EMU bereits aneinander gereiht sind. Das Anreihen der Modulunterteile BMU, EMU erfolgt paßgenau, da die Modulunterteile BMU, EMU durch zusammenwirkende Formschlußaufnahmen 1 und nicht dargestellte Formschlußelemente - z.B. Schwalbenschwanz und Schwalbenschwanzaufnahme 1 - geführt sind. Durch die formschlüssige Verbindung der Modulunterteile BMU, EMU ist der anreihfähige Aufbau des modularen Peripheriegerätes PG selbsttragend.

Diese paßgenaue Führung ist erforderlich, damit die Elemente des Dichtsystemes exakt ineinander greifen. Zum Erreichen der einer hohen Schutzart ist im Ausführungsbeispiel das Dichtsystem als Feder-Nut-Kombination ausgebildet. Die Feder des Moduloberteils BMO, EMO greift in die Nut N des Modulunterteils BMU, EMU ein. Die Dichtung wird in die Nut N des Modulunterteils BMU, EMU geschlossenporig eingeschäumt. Sowohl die einzelnen Module als auch das erweiterbare Peripheriegerät erfüllen damit die Kriterien der Schutzart IP65 nach DIN IEC 529.

Üblicherweise werden die Modulunterteile BMU, EMU auf einer Auflagefläche befestigt, dazu weisen die Modulunterteile BMU, EMU Bohrungen 2 auf, in die Befestigungsmittel, wie z.B. Schrauben, einführbar sind. Mit den Befestigungsmitteln sind die Modulunterteile BMU, EMU einzeln auf der Auflagefläche fixierbar.

Die aneinander gereihten Modulunterteile BMU, EMU werden durch Verschrauben oder mittels gleichwirkender Befestigungsmittel aneinander befestigt. Die Modulunterteile BMU, EMU weisen dafür die Bohrungen 3, 3' auf, in die z.B. Schrauben einführbar sind. In einer nicht dargestellten Ausführungsform wird die Befestigung der aneinander gereihten Modulunterteile BMU, EMU durch das Einführen von keilförmigen Verriegelungsmitteln bewirkt.

Wie man weiterhin besonders aus FIG 2 erkennt, sind die Moduloberteile BMO, EMO ohne Lösung der Verbindung der Modulunterteile BMU, EMU von den jeweiligen Unterteilen BMU, EMU abnehmbar und somit im Wartungsfalle oder bei veränderter Anlagenkonfiguration leicht auswechselbar. Dies ergibt sich aus dem Umstand, daß in einer vorteilhaften Ausgestaltung jedes Moduloberteil BMO, EMO jeweils nur am korrespondierenden Modulunterteil BMU, EMU mit zumindest einem Befestigungsmittel befestigt ist und das die Betätigung der Befestigungsmittel durch andere Moduloberteile BMO, EMO oder Modulunterteile BMU, EMU nicht versperrt ist. Dazu weist das Moduloberteil BMO, EMO Bohrungen 4' auf, durch die Befestigungsmittel, z.B. Schrauben, hindurchführbar sind, die in entsprechende Bohrungen 4 im Modulunterteil BMU, EMU eingreifen, so daß die Moduloberteile BMO, EMO auf den Modulunterteilen BMU, EMU fixierbar sind.

Im Ausführungsbeispiel gemäß FIG 1 bzw. FIG 2 weist das Basismodul drei Anschlußstecker AS1, AS2, AS3 auf. Zwei dieser Anschlußstecker AS2, AS3 sind zusammen auf einer Steckerplatte SP montiert. Üblicherweise wird über den Anschlußstekker AS1 dem Peripheriegerät die mindestens eine Versorgungsspannung zugeführt. Über die Anschlußstecker AS2, AS3 wird beispielsweise die Feldbusleitung durch das Peripheriegerät geschleift. Dabei ist es vorteilhaft, daß die Anschlußstecker AS2, AS3 auf einer Steckerplatte SP montiert sind, denn dann ist es - wenn die eingehende und die abgehende Feldbusleitung in den Anschlußsteckern AS2, AS3 verbunden ist - nicht erforderlich, die Feldbusleitung beim Lösen der aus den Anschlußsteckern AS2, AS3 und der Steckerplatte SP gebildeten Steckeinheit zu unterbrechen. Die Kommunikationsverbindung zwischen eventuellen weiteren Peripheriegeräten bleibt somit bestehen.

Die Modulunterteile BMU, EMU der einzelnen Module des modularen Peripheriegerätes weisen eine Vielzahl von Kontaktelementen LE auf, welche die Signal- bzw. Versorgungsspannung weiterleiten. Die Kontaktelemente LE sind als im wesentlichen U-förmige Kontaktelemente LE ausgebildet und in den Modulunterteilen BMU, EMU auf der Seite des anreihfahigen Profils angeordnet.

Der eine Schenkel der U-förmigen Kontaktelemente LE befindet sich bei aufgesetztem Moduloberteil BMO, EMO innerhalb des Moduls so daß die Vielzahl dieser Schenkel der U-förmigen Kontaktelemente LE eine interne Kontaktanordnung IML - im Ausführungsbeispiel eine interne Messerkontaktleiste IML - bildet. Der andere Schenkel der U-förmigen Kontaktelemente LE befindet sich auch bei aufgesetztem Moduloberteil BMO, EMO außerhalb des Moduls so daß die Vielzahl dieser Schenkel der U-förmigen Kontaktelemente LE eine externe Kontaktanordnung EML - im Ausführungsbeispiel eine externe Messerkontaktleiste EML - bildet.

Beim Anreihen eines Erweiterungsmoduls an das Basismodul BM greift die externe Messerkontaktleiste EML des Basismoduls BM so in das Erweiterungsmodul ein, daß die externe Messerkontaktleiste EML des Basismoduls der internen Messerkontaktleiste IML des angereihten Erweiterungsmoduls gegenüberliegt. Für das Anreihen eines weiteren Erweiterungsmoduls an ein Erweiterungsmoduls gelten die beschriebenen Verhältnisse entsprechend. Im übrigen sind sie besonders gut aus der Darstellung in FIG 2 ersichtlich.

Diejenige externe Messerkontaktleiste EML, die nicht durch ein weiteres angereihtes Erweiterungsmodul abgedeckt wird, wird statt dessen durch ein spezielles Endstück ES abgedeckt. Durch das Endstück ES ist in gleicher Weise ein Berührungsschutz wie auch die für die angestrebte Schutzart erforderliche Abdichtung erreicht. Weiterhin ist es damit möglich, die Erweiterungsmodule im wesentlichen baugleich zu halten, so daß als Abschlußmodul kein spezielles Erweiterungsmodul erforderlich ist.

Durch eine elektrische Schaltung, an die Sensoren und/oder Aktoren anschließbar sind, die üblicherweise zusammen oder in Verbindung mit dem Moduloberteil BMO, EMO aufgebracht wird, wird die gewünschte elektrisch leitende Verbindung zwischen zumindest einem Teil der Kontaktelemente LE, der einzelnen Modulunterteile BMU, EMU hergestellt.

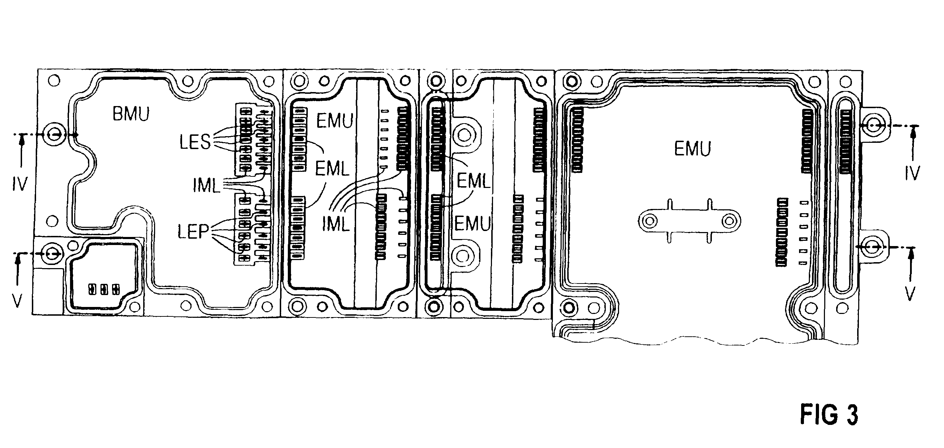

FIG 3 zeigt eine Draufsicht auf die aneinandergereihten Modulunterteile BMO, EMO. Man erkennt jeweils die interne Messerkontaktleiste IML und die externe Messerkontaktleiste EML. Ein Teil der Kontaktelemente LE der Messerkontaktleisten IML, EML dient der Weiterleitung der mindestens einen Versorgungsspannung, ein anderer Teil der Kontaktelemente LE dient der Weiterleitung der Signalspannungen.

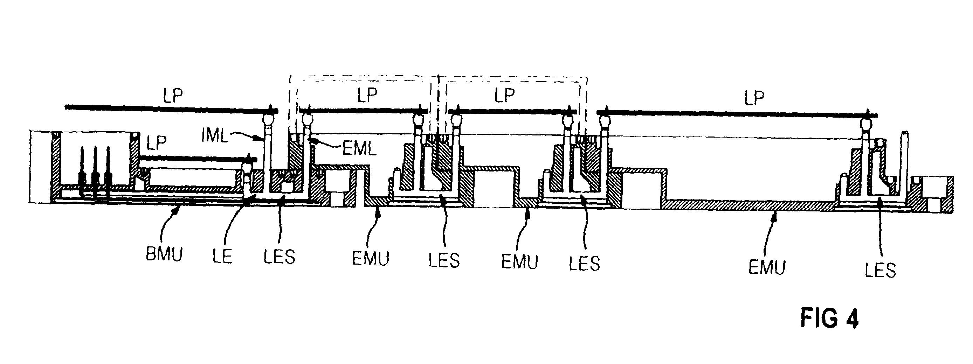

Die Weiterleitung der Signalspannungen läßt sich besonders gut anhand von FIG 4 verdeutlichen. Mit den in FIG 4 nicht dargestellten Anschlußsteckern AS2, AS3 ist eine Feldbusleitung an das Peripheriegerät anschliessbar. Mit dieser Feldbusleitung werden die Signalspannungen in das Basismodul des Peripheriegerätes eingespeist. Mittels im Basismodul angeordneter Leiterplatten LP gelangen die Signalspannungen an die Kontaktelemente LE der internen Messerkontaktleiste IML des Basismoduls. Über die sich auf den Leiterplatten LP befindenden Leiterbahnen ergebenden sich dabei die elektrisch leitenden Verbindungen zwischen den nicht dargestellten Kontakten der Anschlußstecker AS2, AS3 und den Kontaktelementen LE der internen Messerkontaktleiste IML.

Diejenigen Kontaktelemente LE der internen Messerkontaktleiste IML, die der Weiterleitung der Signalspannung dienen, werden im folgenden mit dem Bezugszeichen LES versehen.

Über die im wesentlichen U-förmigen Kontaktelemente LES stehen die Signalspannungen unmittelbar auch an der externen Messerkontaktleiste EML und damit räumlich bereits im Bereich des angereihten Erweiterungsmodul an. Die Weiterleitung der Signalspannungen von der externen Messerkontaktleiste EML des Basismoduls zur internen Messerkontaktleiste IML des Erweiterungsmoduls erfolgt über Leiterbahnen einer Leiterplatte LP oder über andere geeignete Verbindungsmittel. Im Ausführungsbeispiel ist auch im Erweiterungsmoduloberteil EMO eine Leiterplatte LP angeordnet. Beim Aufsetzen der Leiterplatte auf das Erweiterungsmodulunterteil EMU ergibt sich eine elektrisch leitende Verbindung zwischen Kontaktelementen der Leiterplatte LP im Erweiterungsmoduloberteil EMO und den U-förmigen Kontaktelementen LES. Im Ausführungsbeispiel befindet sich auf der Leiterplatte LP ein Bus-ASIC. Über den Bus-ASIC ist eine Integration des jeweiligen Erweiterungsmoduls in den auf dem Bus stattfindenden Datenverkehr gewährleistet. Weiterhin kann der Bus-ASIC auch die Auffrischung der über den Bus laufenden Signalspannungen übernehmen. Die in dem Bus-ASIC eingehenden Signalspannungen werden selbstverständlich auch über die entsprechenden Kontaktelemente LES in der zuvor beschriebenen Weise an eventuell weitere Erweiterungsmodule weitergeleitet. Bei Verzicht auf den Bus-ASIC ist eventuell auch eine 1:1-Verbindung der die Signalspannung weiterleitenden Kontaktelemente LES über die Leiterbahnen der Leiterplatte LP denkbar.

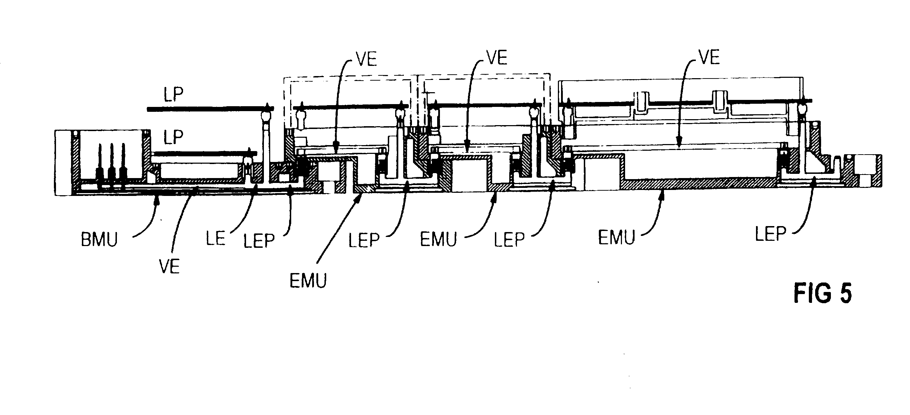

Die Weiterleitung der Lastspannungen kann besonders gut anhand von FIG 5 verdeutlicht werden. Die mindestens eine Versorgungsspannung wird dem Basismodul des Peripheriegerätes über den in FIG 5 nicht dargestellten Anschlußstecker AS1 zugeführt. Von den nicht dargestellten Kontaktelementen des Anschlußsteckers AS1 erfolgt innerhalb des Basismodul unterteils BMU mittels elektrisch leitender Verbindungselemente VE eine Weiterleitung der Versorgungsspannung an Kontaktelemente LE der internen Messerkontaktleiste IML des Basismoduls. Diejenigen Kontaktelemente LE, die ausschließlich der Weiterleitung der Versorgungsspannung dienen, werden im folgenden mit dem Bezugszeichen LEP bezeichnet.

Im Gegensatz zu den Signalspannungen werden die Versorgungsspannungen nicht über die im Moduloberteil BMO, EMO angeordnete elektrische Schaltung von der externen Messerkontaktleiste EML an die interne Messerkontaktleiste IML weitergeleitet, sondern über geeignete, im Modulunterteil BMO, EMO angeordnete, elektrisch leitende Verbindungselemente VE. Dies hat den Vorteil, daß die Lastspannungen nicht in jedem Fall über die im Moduloberteil BMO, EMO angeordnete elektrische Schaltung geführt werden muß, sondern dort nur dann ansteht, wenn sie tatsächlich benötigt wird.

Vorteilhafterweise ist damit an der im Moduloberteils BMO, EMO angeordneten elektrischen Schaltung nur eine Auswahl der Versorgungsspannungen abgreifbar, so daß sich die Möglichkeit ergibt, im Bereich der elektrischen Schaltung nur diejenigen Versorgungsspannungen zu verwenden, die auch tatsächlich benötigt werden.

Dies ist insbesondere in bezug auf die Wärmeentwicklung im Bereich des Moduloberteils BMO, EMO, aber auch in bezug auf mögliche Störungen durch elektromagnetische Strahlung vorteilhaft. Wird eine bestimmte Versorgungsspannung in einer der in den Moduloberteilen BMO, EMO angeordneten elektrischen Schaltungen benötigt, so ist ein entsprechendes Kontaktelement so ausgebildet, daß die Versorgungsspannung direkt auf der Leiterplatte LP abgreifbar ist. Auf diese Weise werden tatsächlich nur diejenigen Versorgungsspannungen an die elektrische Schaltung herangeführt, die dort auch tatsächlich benötigt werden. Alle anderen Versorgungsspannungen werden in der oben beschriebenen Form 1:1 mittels der jeweiligen Verbindungselemente VE durch das betreffende Modul hindurchgeschleift.

Durch die Anreihung von Erweiterungsmodulen entsteht ein selbstaufbauender Bus, wobei der Bus sowohl Signal- als auch Versorgungsspannungen umfassen kann. Durch Abgriff der Versorgungsspannungen und Auswertung der Signalspannungen ist mit Hilfe der in den Moduloberteilen BMO, EMO angeordneten elektrischen Schaltung eine Steuerung und/oder Überwachung eines technischen Prozesses möglich. Da die jeweilige elektrische Schaltung in den Moduloberteilen BMO, EMO angeordnet ist, ist sie im Wartungsfalle leicht austauschbar. Die in den Moduloberteilen BMO, EMO befindliche elektrische Schaltung, ist mit den jeweiligen Modulunterteilen EMU, BMU bzw. mit den in diesen befindlichen Kontaktelementen LE elektrisch über geeignete Steckverbinder, insbesondere über TIMER-Kontakte, verbindbar. Bedarfsweise weisen die Schenkel der U-förmi ge Kontaktelemente LE Verzweigungen, z.B. für einen Mehrfachabgriff der jeweiligen Spannung, auf.

Sämtliche Anzeige- und Anschlußelemente sind auf der Frontseite, also auf der Moduloberseite BMO, EMO angeordnet, so daß sie für den Anschluß von Sensoren oder Aktoren des technischen Prozesses leicht zugänglich sind.

Die Einbaulage des Peripheriegerätes ist beliebig und kann sich daher nach den Erfordernissen am Einsatzort bzw. nach den Erfordernissen der Anwendungsart richten. Dadurch, daß die Signal- oder Versorgungsspannung führenden Verbindungen komplett innerhalb der jeweiligen Modulgehäuse verbleiben, läßt sich ein ausgezeichneter Schutz gegen unerwünschte emittierte oder immittierte elektromagnetische Strahlung erreichen. Sollte der Schutz der Modulgehäuse im Falle von nicht oder nur teilweise metallischen Modulgehäusen nicht ausreichen, kann zusätzlich entweder auf die Innenseite oder die Außenseite der Modulgehäuse eine Abschirmung aufgebracht werden.

In einer speziellen, nicht dargestellten Ausführungsform wäre es auch denkbar, daß, wie bereits angedeutet, die Modulunterteile BMU, EMU und/oder die Moduloberteile BMO, EMO anstelle des anreihfahigen Profils spezielle Formschlußelemente aufweisen, mit denen auch ein formschlüssiges Anreihen der Module möglich wäre. Ein Beispiel für solche Formschlußelemente wären Zapfen, die in entsprechende Ausnehmungen des Nachbarmoduls eingreifen. Wenn die Zapfen selbst Ausnehmungen aufweisen, ist es möglich, das Modul im angereihten Zustand durch Einführen von stift- oder keilförmigen Befestigungsmitteln in die Ausnehmungen der Zapfen am Nachbarmodul zu arretieren. In der speziellen, nicht dargestellten Ausführungsform werden die stift- oder keilförmigen Befestigungsmittel in entsprechende Ausnehmungen im Moduloberteil BMO, EMO eingeführt, wobei die Befestigungsmittel zumindest bis in die Ausnehmungen der Zapfen des angereihten Nachbarmoduls reichen, so daß dieses formschlüssig arretiert ist.

## Patentansprüche

1. Modulares, baugruppenweise erweiterbares Peripheriegerät zur Steuerung und/oder Überwachung eines technischen Prozesses, bestehend aus einem Basismodul, dem zumindest eine Versorgungsspannung zuführbar ist, an das mindestens ein Erweiterungsmodul anreihbar ist, wobei sowohl das Basismodul als auch das mindestens eine anreihbare Erweiterungsmodul mit Aktoren und/oder Sensoren zur Steuerung und/oder Überwachung des technischen Prozesses verbindbar ist, wobei die Module aus einem Moduloberteil (BMO, EMO) und einem Modulunterteil (BMU, EMU) bestehen und die Modulunterteile (BMU, EMU) jeweils ein aneinander anreihfähiges Profil aufweisen, **dadurch gekennzeichnet**, daß
- die Modulunterteile (BMU, EMU) im Bereich des anreihfahigen Profils eine Vielzahl von im wesentlichen U-förmigen Kontaktelementen (LE) aufweisen,
- der eine Schenkel der U-förmigen Kontaktelemente (LE) sich bei aufgesetztem Moduloberteil (BMO, EMO) innerhalb des Moduls befindet, so daß die Vielzahl dieser Schenkel der U-förmigen Kontaktelemente (LE) eine interne Kontaktanordnung (IML) bildet,
- der andere Schenkel der U-förmigen Kontaktelemente (LE) sich auch bei aufgesetztem Moduloberteil (BMO, EMO) außerhalb des Moduls befindet, so daß die Vielzahl dieser Schenkel der U-förmigen Kontaktelemente (LE) eine externe Kontaktanordnung (EML) bildet,
- die externe Kontaktanordnung (EML) beim Anreihen eines Erweiterungsmoduls so in das Erweiterungsmodul eingreift, daß die externe Kontaktanordnung (EML) der internen Kontaktanordnung (IML) des angereihten Erweiterungsmoduls gegenüberliegt.

2. Peripheriegerät nach Anspruch 1, **dadurch gekennzeichnet**, daß die im wesentlichen U-förmigen Kontaktelemente (LE) Verzweigungen aufweisen.

3. Peripheriegerät nach Anspruch 1 oder 2, **dadurch gekennzeichnet**, daß
- ein Teil der im wesentlichen U-förmigen Kontaktelemente (LE) der Weiterleitung der mindestens einen Versorgungsspannung dient und
- ein Teil der im wesentlichen U-förmigen Kontaktelemente (LE) der Weiterleitung von Signalspannungen dient.

4. Peripheriegerät nach Anspruch 1, 2 oder 3, **dadurch gekennzeichnet**, daß die Moduloberteile (BMO, EMO) eine auf einer Leiterplatte (LP) aufgebrachte, den technischen Prozeß steuernde und/oder überwachende elektrische Schaltung aufweisen.

5. Peripheriegerät nach Anspruch 3 und 4, **dadurch gekennzeichnet**, daß
- die mindestens eine Versorgungsspannung durch das Modul durch direkte, elektrisch leitende Verbindungselemente (VE) zwischen externer Kontaktanordnung (EML) und interner Kontaktanordnung (IML) hindurchschleifbar ist und
- die Signalspannungen über die in den Moduloberteilen (BMO, EMO) angeordneten Leiterplatten (LP) von der externen Kontaktanordnung (EML) zu der internen Kontaktanordnung (IML) durch das Modul hindurchschleifbar sind.

6. Peripheriegerät nach Anspruch 4 oder 5, **dadurch gekennzeichnet**, daß nur eine Auswahl der Versorgungsspannungen auf der Leiterplatte (LP) abgreifbar ist und die auf der Leiterplatte (LP) abgreifbaren Versorgungsspannungen durch entsprechend ausgestaltete Kontaktelemente an die Leiterplatte (LP) herangeführt sind.

## Claims

1. Modular peripheral unit which can be extended by assemblies for controlling and/or monitoring a technical process, comprising a basic module to which at least one supply voltage can be supplied and with which at least one extension module can be arranged in a row, it being possible to connect both the basic module and the at least one extension module which can be arranged in a row to actuators and/or sensors for controlling and/or monitoring the technical process,
- the modules comprising a module upper part (BMO, EMO) and a module lower part (BMU, EMU) and
- the module lower parts (BMU, EMU) each having a profile such that they can be arranged in a row with one another,
characterized in that
- the module lower parts (BMU, EMU) have a multiplicity of essentially U-shaped contact elements (LE) in the region of the profile with which they can be arranged in a row with one another,
- one limb of the U-shaped contact elements (LE) is located within the module when the module upper part (BMO, EMO) is fitted, such that the multiplicity of these limbs of the U-shaped contact elements (LE) form an internal contact arrangement (IML),
- the other limb of the U-shaped contact elements (LE) is located outside the module even when the module upper part (BMO, EMO) is fitted, such that the multiplicity of these limbs of the U-shaped contact elements (LE) form an external contact arrangement (EML),
- the external contact arrangement (EML) engages in an extension module when the extension module is arranged in a row, such that the external contact arrangement (EML) is opposite the internal contact arrangement (IML) of the extension module which is arranged in a row.

2. Peripheral unit according to Claim 1, characterized in that the essentially U-shaped contact elements (LE) have branches.

3. Peripheral unit according to Claim 1 or 2, characterized in that
- some of the essentially U-shaped contact elements (LE) are used for passing on the at least one supply voltage, and
- some of the essentially U-shaped contact elements (LE) are used to pass on signal voltages.

4. Peripheral unit according to Claim 1, 2 or 3, characterized in that the module upper parts (BMO, EMO) have an electrical circuit which is fitted on a printed circuit board (LP) and controls and/or monitors the technical process.

5. Peripheral unit according to Claims 3 and 4, characterized in that
- the at least one supply voltage can be looped through the module through direct electrically conductive connecting elements (VE) between the external contact arrangement (EML) and the internal contact arrangement (IML), and
- the signal voltages can be looped through the module from the external contact arrangement (EML) to the internal contact arrangement (IML) via the printed circuit boards (LP) which are arranged in the module upper parts (BMO, EMO).

6. Peripheral unit according to Claim 4 or 5, characterized in that only a selection of the supply voltages can be picked off on the printed circuit board (LP), and the supply voltages which can be picked off on the printed circuit board (LP) are passed to the printed circuit board (LP) by means of appropriately designed contact elements.

## Revendications

1. Périphérique modulaire, extensible par modules, destiné à la commande et/ou à la surveillance d'un processus technique et constitué d'un module de base auquel au moins une tension d'alimentation peut être appliquée et auquel au moins un module d'extension peut être adjoint, dans lequel, aussi bien le module de base que le ou les modules d'extension pouvant être adjoints peuvent être reliés à des actionneurs et/ou à des capteurs pour la commande et/ou pour la surveillance du processus technique,
les modules étant constitués d'une partie supérieure de module (BMO, EMO) et d'une partie inférieure de module (BMU, EMU),
les parties inférieures de modules (BMU, EMU) comportant chacune un profil pouvant s'adjoindre, caractérisé par le fait que
- les parties inférieures de modules (BMU, EMU) comportent dans la zone du profil pouvant être adjoint une pluralité d'éléments de contact (LE) sensiblement en forme de U,
- une branche des éléments de contact (LE) en forme de U se trouve à l'intérieur du module lorsque la partie supérieure de module (BMO, EMO) est posée, de telle sorte que la pluralité de ces branches des éléments de contact (LE) en forme de U constitue un dispositif de contact interne (IML),
- l'autre branche des éléments de contact (LE) en forme de U se trouve à l'extérieur du module lorsque la partie supérieure de module (BMO, EMO) est posée, de telle sorte que la pluralité de ces branches des éléments de contact (LE) en forme de U constitue un dispositif de contact externe (EML),
- lors de l'adjonction d'un module d'extension, le dispositif de contact externe (EML) pénètre de manière telle dans le module d'extension que le dispositif de contact externe (EML) se trouve en face du dispositif de contact interne (IML) du module d'extension adjoint.

2. Périphérique selon la revendication 1, caractérisé par le fait que les éléments de contact (LE) sensiblement en forme de U comportent des ramifications.

3. Périphérique selon la revendication 1 ou 2, caractérisé par le fait que
- une partie des éléments de contact (LE) sensiblement en forme de U sert à la retransmission de la ou des tensions d'alimentation, et que
- une partie des éléments de contact (LE) sensiblement en forme de U sert à la retransmission de tensions de signaux.

4. Périphérique selon la revendication 1, 2 ou 3, caractérisé par le fait que les parties supérieures de modules (BMO, EMO) comportent un circuit électrique déposé sur une plaquette à circuit imprimé (LP) et commandant et/ou surveillant le processus technique.

5. Périphérique selon la revendication 3 ou 4, caractérisé par le fait que
- la ou les tensions d'alimentation peuvent, par le module, être appliquées en boucle par des éléments de liaison électriquement conducteurs directs (VE) entre un dispositif de contact externe (EML) et un dispositif de contact interne (IML), et que
- les tensions de signaux peuvent, par le module, être appliquées en boucle du dispositif de contact externe (EML) au dispositif de contact interne (IML) par l'intermédiaire des plaquettes à circuit imprimé (LP) prévues dans les parties supérieures de modules (BMO, EMO).

6. Périphérique selon la revendication 4 ou 5, caractérisé par le fait que seulement une sélection des tensions d'alimentation peut être prélevée de la plaquette à circuit imprimé (LP) et les tensions d'alimentation pouvant être prélevées de la plaquette à circuit imprimé (LP) peuvent être appliquées à la plaquette à circuit imprimé (LP) par des éléments de contact conçus en conséquence.
